Europäisches Patentamt

European Patent Office

Office européen des brevets

(11) Publication number: **0 012 545**
**A1**

(12) # EUROPEAN PATENT APPLICATION

(21) Application number: 79302736.8

(22) Date of filing: 30.11.79

(51) Int. Cl.³: **H 01 L 27/08, H 01 L 29/36, H 01 L 21/76**

(30) Priority: 04.12.78 US 965992

(43) Date of publication of application: 25.06.80
Bulletin 80/13

(84) Designated Contracting States: DE FR GB IT NL

(71) Applicant: **Western Electric Company, Incorporated, 222 Broadway, New York N.Y. 10038 (US)**

(72) Inventor: **Agraz-Guerena, Jorge, 1165 Stafore Drive, Bethlehem, Pennsylvania 18017 (US)**
Inventor: **Panousis, Peter Theodore, 1164 Clearwood Drive, Allentown, Pennsylvania 18103 (US)**
Inventor: **Pritchett, Robert Leonard, R. D. 3, Bath, Pennsylvania 18014 (US)**

(74) Representative: **Watts, Christopher Malcolm Kelway, Dr. et al, Western Electric Company Limited 5, Mornington Road, Woodford Green Essex, IG8 0TU (GB)**

(54) Semiconductor integrated circuit and fabrication method.

(57) A semiconductor integrated circuit includes an upward mode (13, 19A, 17C) and a downward mode (34, 25, 17D, 14) vertical transistor, both of the same polarity (npn). The impurity concentrations in the base zones of both transistors are graded, decreasing towards the collector. A lateral transistor (21, 17B, 22) can be merged with the upward mode transistor to provide an I²L element and local oxide regions (36–40) can be provided for isolation by low temperature, high pressure oxidation so as to cause substantially no movement or segregation of impurities.

ACTORUM AG

- 1 -

(J.Agraz-Guerena 4-8-7)

"Semiconductor Integrated Circuit
and Fabrication Method"

This invention relates to semiconductor integrated circuits including a plurality of bipolar transistors.

Transistors in integrated circuits conventionally are fabricated for optimum operation in the downward mode because the diffusion of impurities is downward from the top surface so that impurity concentration gradients thus produced enhance the performance of transistors operated in the downward mode. These transistors are referred to as downward transistors. Conventionally the base zone is formed by impurity introduction followed by a similar process for forming the emitter zone. Generally this enables some control over the width of the base zone, an important factor in transistor switching speed. Moreover, the emitter zone is usually the smallest zone of the transistor and thus usually has the least parasitic capacitance. In circuit configurations in which the collector is connected to a fixed voltage node, the smaller emitter advantageously is connected to a varying node so as to reduce the power required to switch the transistor. However, there are integrated circuit configurations in which the emitter is connected to a fixed voltage node and it would be desirable to have a small collector region to connect to the varying node.

In integrated injection logic, also termed merged transistor logic, the switching transistor is operated in the upward mode. Circuits have been proposed providing other forms of logic on the same chip with injection logic. These considerations suggest the desirability of providing within one semiconductor integrated circuit chip, transistor configurations suitable for operating in both the downward and upward mode and which also may include lateral transistors suitable for merged transistor logic structures.

Upward mode transistors having up-diffused base zones are known, as disclosed, for example, in U.S. Patent 4,101,349. The upward mode transistor of this disclosure primarily is of the junction isolated type which is generally accompanied by high parasitic effects, particularly capacitances. Moreover, for transistors with suitable analog capability, a higher degree of isolation, such as is provided by local oxide regions, is desirable. Although briefly suggested in the above-noted reference, the form of oxide isolation thus disclosed involves certain disadvantages. In particular, isolation regions of silicon oxide are formed by thermal oxidation of silicon semiconductor material. Insofar as applicants are aware, the practice heretofore has been to perform such oxidation at relatively high temperatures. This appears to have several disadvantages. If done subsequent to impurity implantation and diffusion, the thermal oxidation temperature tends to move the precisely placed PN junctions and to change impurity concentration gradients. The growth of silicon oxide at high temperature also causes an impurity segregation in semiconductor material adjoining the oxide rendering the adjoining zones susceptible to conductivity type inversion. Conduction channels stemming from such inversion are countered by channel stops requiring additional fabrication steps.

U.S. Patent 4,087,900 to A. A. Yiannoulos discloses an injection logic configuration in a semiconductor chip which also includes downward mode transistors. However, the upward mode transistor is the

0012545

injector rather than the switching transistor and is of the opposite conductivity type and thus does not lend itself to the flexibility of application provided where upward and downward transistors are of the same polarity and are roughly comparable in frequency response and speed. The Yiannoulos patent does not utilise oxide isolation and is a relatively complex fabrication procedure.

In the integrated circuit as claimed a pair of vertical transistors of the same polarity are included in a single integrated circuit, one being an upward mode transistor and the other a downward mode transistor. The transistors can thus be made to have comparable speed and other performance characteristics and, contrary to what might be supposed, this can be achieved without signigicantly complicating the fabrication process. Thus, the invention gives the circuit designer the flexibility to choose or combine, as appropriate, transistors in which the emitter is the smallest zone or in which the collector is the smallest zone to optimise the power-delay product for each of the various parts of an integrated circuit. Also, by combining upward and downward mode transistors using a common buried region, a significant reduction in circuit area may be obtained.

Furthermore, in the fabrication method as claimed electrical isolation is provided by local oxide regions thermally grown at a sufficiently low temperature that there is substantially no movement impurities already enplaced or impurity segregation.

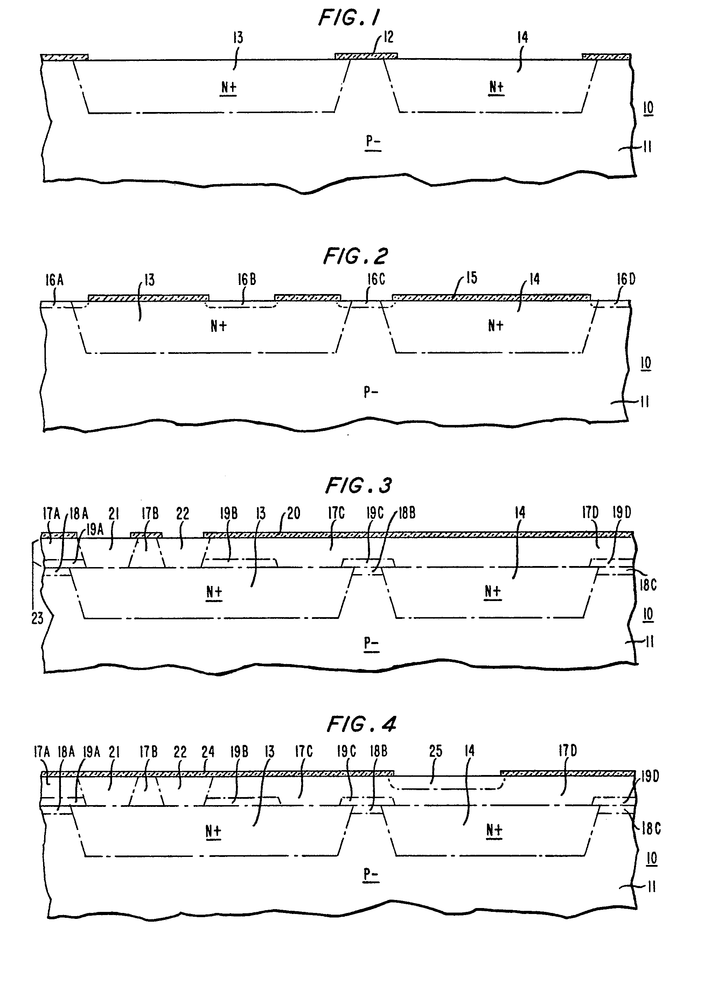

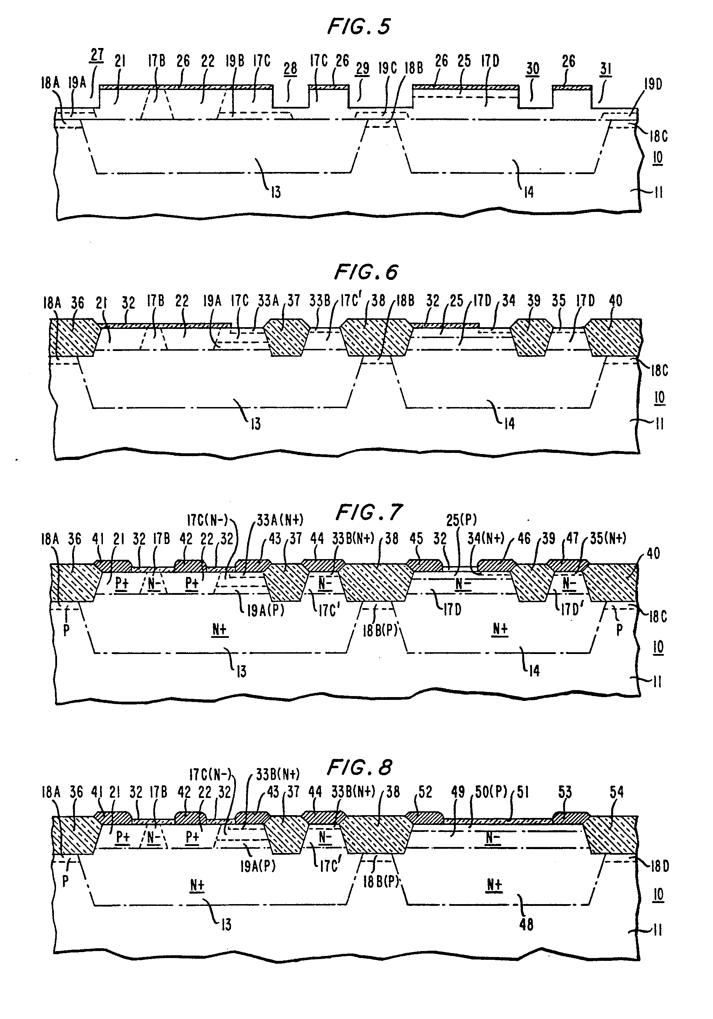

Some embodiments of the invention will now be described by way of example with reference to the accompanying drawings of which FIGS. 1 to 7 show in section a portion of an integrated circuit according to the invention in successive stages of fabrication and FIG. 8 shows in section another portion of an integrated circuit according to the invention.

Referring first to FIG. 7, the cross sectional view shows a portion 10 of a silicon semiconductor chip which includes vertical upward and downward transistors and a lateral transistor and in which isolation is provided both in a conventional manner by reverse-biased PN junctions and more particularly by local oxide regions. The left portion of the structure shown in FIG. 7 which includes, and is above, the N+ buried layer 13, comprises an injection logic portion consisting of a PNP lateral transistor which is the injector and an NPN vertical transistor functioning in the upward mode and constituting the switching transistor of the logic configuration. The lateral transistor is composed of the P zone 21, the N zone 17B and P zone 22. The upward mode switching transistor comprises the N+ emitter zone 13, the P-type base zone 19A and N-type collector zone 17C. As is known, the base of the switching transistor and the collector of the injector transistor are merged. These are the P-type zones 19A and 22, and electrode 42 thus is both a collector contact for the lateral transistor and a base contact for the switching transistor. Electrode 41 is the injector contact to the P-type emitter 21. Electrode 43 is the collector contact of the switching transistor and electrode 44 is the contact through N zones 33B and 17C' to the N-type emitter zone 13. In the right portion of the chip portion 10 above the N-type buried zone 14, there is provided a conventional NPN transistor for operating in the downward mode. This transistor comprises the N-type emitter 34, P-type base zone 25 and N-type collector zones 17D and 14. Contact to the collector zone is by way of N-type zones 35 and 17D'. Electrode 45 to P-type base zone 25 constitutes the base electrode, electrode 46 is the emitter electrode and electrode 47 is the collector electrode. Dielectric isolation between the several active portions of this structure is provided by local oxide regions 36, 37, 38, 39 and 40.

FIG. 8 is similar to FIG. 7 in that there is depicted in the left portion of the chip 10 an integrated injection logic unit comprising the lateral and the upward mode transistor. The portion on the right over buried layer 48 is a diffused resistor consisting of the P-type zone 50 formed in the N-type epitaxial layer 49.
Electrodes 52 and 53 are the terminals of the resistor and
dielectric layer 51, which may consist of silicon oxide or
nitride or both, is a passivating coating. Resistors of
this type are an essential element of logic circuits and,
as will be explained hereinafter, advantageously are
fabricated integrally with the other elements of the
integrated circuit. A downward mode vertical transistor
on another part of the chip 10 is not shown in FIG. 8.

Also, as will be more clearly illustrated by the
following description of the fabrication procedure, the
devices described in FIGS. 7 and 8 have advantageous
impurity concentration distributions which enhance their
performance. Moreover, as will also become apparent, the
structures of FIGS. 7 and 8 are achieved using a procedure
which is comparable to the basic conventional procedure for
fabricating semiconductor integrated circuits, in
particular those of the standard buried collector
configuration. This fabrication procedure will now be
described.

Referring to FIG. 1, the starting material for
the semiconductor wafer of which the chip portion 10 is a
part is single crystal silicon semiconductor material
having a relatively low concentration of an acceptor
impurity, typically boron at a concentration, for example,
of about $2 \times 10^{14}$ atoms per cubic centimetre. This is a
relatively lightly doped material usually referred to as
having $\pi$ type conductivity and is oriented in or close
to one of the major crystalline orientations.

As shown in FIG. 1 there is formed in this chip
portion a pair of N-type conductivity zones 13 and 14 by
the conventional use of a mask 12 and diffusion, or ion
implantation and diffusion, using a donor impurity such as
antimony. Typically these buried layers 13 and 14 have a
final depth of about 5.0 microns and a resistivity of about
20 ohms per square.

Referring to FIG. 2, the next step is to
introduce selectively into the top surface of the chip portion 10 an acceptor impurity using a reformed mask 15.
In a typical procedure, boron is introduced by ion
implantation using a relatively heavy dosage of about
$2 \times 10^{14}$ atoms per square centimetre at 100 KEV to form the
P-type implanted zones 16A, 16B, 16C and 16D. A suitable
diffusion cycle is used to flatten the concentration
profile of these impurities within one micron or so from
the surface. Zones 16A, 16C and 16D are shown as
contacting buried layers 13 and 14. However, these zones
ultimately function as channel stops and need not extend
completely over the space between buried layers in order to
fulfil that function.

The semiconductor body then is cleaned and any
masking material removed. Next, as shown in FIG. 3, an
epitaxial layer 23 is deposited on the surface of the
portion 10. This process may be a conventional vapour
deposition of single crystal silicon in an epitaxial
reactor to produce an N-type conductivity layer of about
0.3 ohm centimetres and about 2.5 microns in thickness.
Typically, arsenic is used as the impurity in the epitaxial
layer. Immediately following the epitaxial deposition step
the chip portion surface is covered by a new mask 20 which
defines zones 21 and 22 into which boron is diffused to
convert these portions to P-type conductivity. Typically
these are relatively heavily doped zones which may be
referred to as an extrinsic base in the case of zone 22.

During the heat treatment to which the chip
portion 10 is subjected during the deposition and diffusion
steps, the boron impurity selectively implanted into the
surface of the original chip portion in zones 16A-16D,
diffuses upwardly into the epitaxial layer 23. This upward
diffusion forms the P-type zones 19A-19D. The P-type
concentration in these zones consequently is graded in the
direction towards the upper surface of the chip portion.
The fairly heavy N-type concentration in the buried layer
zones 13 and 14 overdopes the presence of boron impurities.
However, there is a relatively heavy boron concentration in
the π type conductivity portions 11 between the buried zones constituted by the zones 18A, 18B and 18C. These zones function as channel stops as previously noted. In a typical embodiment the total upward diffusion defining the location of the PN junction is about 0.6 microns with approximately one-half of the upward diffusion occurring during epitaxial deposition and the balance during extrinsic base diffusion.

The next step is the selective implantation of an acceptor imputity to form the base zone 25 of the downward mode NPN transistor. This step uses the oxide mask 24 and the selective introduction of boron by a suitable means such as a double ion implantation procedure to produce the P-type zone 25 having a resistivity of about 600 ohms per square. A typical double implantation procedure comprises a first dosage of $1 \times 10^{13}$ per square centimetre at 200 KEV and a dosage of $1 \times 10^{14}$ per square centimetre at 40 KEV. This step also forms the diffused P-type resistor zone 50 shown in FIG. 8.

The arrangement shown in FIG. 5 illustrates the selective removal of the material from the surface portion of the chip portion 10 preparatory to the thermal oxidation process. This material is removed in selected areas to form recesses 27-31 to a predetermined depth in preparation for the formation within the recesses of silicon dioxide. The recesses advantageously are produced by suitable etching either chemically or by a plasma process. In a typical example, after the formation of the silicon nitride mask, the surface is selectively etched to a depth of about 0.9 microns to produce the recesses 27-31. An advantageous procedure is a process combining anisotropic and isotropic plasma etching, in which after the anisotropic etching using a process such as is described in British patent application No. 7926037 (publication No. 2026394) a shorter isotropic plasma etching is done using trifluorochloremethane ($CC\ell F_3$).

After forming the recesses and before the thermal oxidation step, it sometimes has been found advantageous to deposit a film of silicon oxide on the entire surface of the chip to prevent lifting or separation of the silicon nitride mask layer during subsequent thermal oxidation. Advantageously this is done by pyrolytic reaction and deposition using as a reactant tetraethyl orthosilicate (TEOS) at a temperature of about 700 degrees C. A deposited oxide thickness of about 200 nm (2000 Å) is suitable.

The thermal growth of the local oxide zones in the unmasked recesses is carried out under conditions of high pressure which enable a lower temperature to be used while retaining a reasonable time for the required growth process. Typically the semiconductor body is installed in a chamber at a pressure in a range of about 20-25 atmospheres, in a steam ambient at a temperature in a range of about 700-900 degrees C for a period of about 8 hours or less. The result is the formation of oxide regions 36, 37, 38, 39 and 40 which penetrate to a depth of about 1.9 microns, or approximately twice the depth of the recesses 27-31 and thus provide dielectric isolation between the separated portions of the chip. Of particular significance is the relatively low temperature at which this process of thermal oxidation is carried out. Because of this there occurs little or no movement of the various critically placed impurities in the chip portion. Not only is the location of the various conductivity type zones significant, but the preservation of the original concentration gradients is important. Low temperature, high pressure oxidation thus has significant advantages, when contrasted with the high temperature processing required to produce an equivalent oxide thickness at atmospheric pressure, typically 1050 degrees C for 12 hours.

Subsequent to the formation of the local oxide regions 36-40, another oxide mask 32 enables the selective introduction of a donor impurity to form the N-type zones 33, 34, and 35. This impurity introduction typically is an ion implantation of arsenic at a dosage of $5 \times 10^{15}$ to produce relatively heavily doped N-type conductivity zones. In particular, zone 34 constitutes the emitter zone of the downward NPN transistor and zones 33 and 35 enable good low resistance contact to the more lightly doped epitaxial zones 17C' and 17D' for making emitter contact to the upward transistor and collector contact to the downward transistor, respectively.

Finally, the structures shown in FIGS. 7 and 8 are produced by a contact window masking step in conventional fashion followed by the formation of the metallic electrodes 41-47 of FIG. 7 and electrodes 41-44, 52, 53 of FIG. 8 as previously described.

In an alternative arrangement of integrated injection logic, the collector output of the NPN switching transistor is a Schottky contact. One such arrangement is disclosed in U.S. Patent 4,076,556 to J. Agraz-Guerena and A. W. Fulton. The upward transistor disclosed herein is particularly suited for such an arrangement because of the relatively low impurity concentration of the N-type zone 17C comprising the collector zone. The alternative Schottky barrier contact is provided merely by omitting the N+ zone 33A. In a preferred embodiment the contact electrodes comprise the series of metals comprising a thin film of platinum which is converted to platinum silicide, followed by layers of titanium, platinum and gold. This contact metallurgy is disclosed in U.S. Patents 3,287,612 and 3,426,252 to M. P. Lepselter. Contacts of this kind form low resistance, substantially ohmic contacts when applied to silicon containing a high impurity concentration and rectifying or Schottky type contacts to moderate or low impurity doped silicon.

As previously noted, referring to FIG. 7, the upward transistor, comprises the emitter zone 13, contacted on the top surface by electrode 44, base zone 19A and collector zone 17C, likewise contacted on the top surface by electrodes 42 and 43, respectively. This transistor has a collector zone of relatively small dimensions and having, as a consequence, relatively low parasitic capacitance. The base zone has a width of about 0.6 microns using current technology.

The downward mode transistor, on the other hand, is relatively conventional having an emitter zone 34 of small dimensions and a larger collector zone 14-17D. Both of these zones as well as the base zone 25 are contacted at the top surface by electrodes 45, 46 and 47. The base width of the zone 25 of the downward mode transistor is about 0.3 microns. The peak frequency cutoff values for the devices are about 900 MHz for the upward mode transistor and in the range of two to three times that value for the downward mode transistor. Thus, the two transistors are comparable in speed.

The upward and downward mode transistors may share a common buried layer or, as particulary described above, may be based on isolated buried layers. The common buried layer may constitute, in effect, a bus to which is connected the collectors of a plurality of downward mode transistors and the emitters of a plurality of upward mode transistors. Moreover, these common buried layer configurations also may include merged laterial transistors.

The arrangement of FIG. 8 which includes in the right portion of the chip a diffused resistor is particularly advantageous in that the resistor is provided simply as a part of the fabrication method which produces the transistors. As previously noted, this process departs from standard buried layer technology only in that it requires one additional selective implant into the original chip for the up-diffused base and one additional diffusion into the epitaxial layer for the extrinsic base. The latter step may be omitted if only the upward and downward mode transistors are formed.

0012545

## CLAIMS

1. A semiconductor integrated circuit comprising a semiconductor body (10) including a plurality of transistors each having an emitter zone (21, 13, 34), a base zone (17B, 19A, 25) and a collector zone (22, 17C, 17D, 14), the body having a major, substantially planar, top surface containing the terminal electrodes (41-47) of all the transistors, characterised in that the transistors include a pair of vertical transistors of the same polarity, one of the transistors (13, 19A, 17C) being an upward mode transistor having a collector zone (17C) adjoining the top surface, the other transistor (34, 25, 17D, 14) being a downward mode transistor and having an emitter zone (34) adjoining the top surface, both transistors of the pair having a significant net impurity concentration gradient in the base zone (19A, 25) which decreases in the direction from emitter zone (13, 34) to the collector zone (17C, 17D, 14) of the respective transistor.

2. A semiconductor integrated circuit as claimed in claim 1 wherein the transistors also include a lateral transistor which has all of its zones (21, 17B, 22) adjoining the top surface and having its collector zone (22) merged with the base zone (19A) of the upward mode transistor.

3. A semiconductor integrated circuit as claimed in claim 2 wherein the base zone (17B) of the lateral transistor is merged with the emitter zone (13) of the upward mode transistor, the lateral and upward mode transistors constituting an integrated injection logic element.

4. A semiconductor integrated circuit as claimed in any of the preceding claims wherein the collector zone (14) of the downward mode transistor and the emitter zone (13) of the upward mode transistor comprise a common buried layer.

5. A semiconductor integrated circuit as claimed in any of the preceding claims including a local

0012545

oxide portion (38) between the upward (13, 19A, 17C) and downward (34, 25, 17D, 14) mode transistors providing at least partial dielectric isolation between them.

6. A method of fabricating a semiconductor integrated circuit from a silicon semiconductor body (10) which includes a plurality of transistors having base zones (17B, 19A, 25) whose width and impurity concentration gradients are determined by diffusion heat treatments, the said transistors being at least partially isolated electrically from one another by local oxide regions (36-40), characterised in that the local oxide regions (36-40) are produced by thermal growth at a temperature in the range of about 700 to 900 degrees C and a pressure in the range of about 20 to 25 atmospheres.

0012545

FIG. 1

FIG. 2

FIG. 3

FIG. 4

0012545

FIG. 5

FIG. 6

FIG. 7

FIG. 8

European Patent Office

**EUROPEAN SEARCH REPORT**

0012545

Application number

EP 79 302 736.8

## DOCUMENTS CONSIDERED TO BE RELEVANT

| Category | Citation of document with indication, where appropriate, of relevant passages | Relevant to claim |
|---|---|---|
| | US - A- 3 993 513 (FAIRCHILD)<br>* claim 3; abstract; fig. 8 *<br>-- | 1-3,5,<br>6 |
| | GB - A - 1 259 069 (HONEYWELL INFORMA-<br>TION SYSTEMS ITALIA)<br>* claim 4; fig. 3 *<br>-- | 1 |
| | DE - A1 - 2 738 810 (MOTOROLA)<br>* claim 7; pages 12 and 13;<br>fig. 4 *<br>-- | 1 |
| P | EP - A1 - 0 000 114 (IBM)<br>* claim 8 *<br>-- | 1 |
| A | US - A - 4 086 610 (MOTOROLA)<br>* claim 1; abstract; fig. 3 and 4 *<br>-- | 1 |
| A | IEEE JOURNAL OF SOLID-STATE CIRCUITS<br>Vol. SC-11, No. 3, June 1976,<br>New York<br>C. MULDER et al. "High speed integrated injection logic $(I^2L)$"<br>* pages 379 to 385 *<br>---- | |

**CLASSIFICATION OF THE APPLICATION (Int. Cl.3)**

H 01 L 27/08
H 01 L 29/36
H 01 L 21/76

**TECHNICAL FIELDS SEARCHED (Int.Cl.3)**

H 01 L 21/76
H 01 L 27/02
H 01 L 29/36

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| | The present search report has been drawn up for all claims | |
|---|---|---|
| Place of search<br>Berlin | Date of completion of the search<br>11-03-1980 | Examiner<br>ROTHER |

EPO Form 1503.1   06.78